(19) **Europäisches Patentamt European Patent Office Office européen des brevets**

(11) **EP 4 672 548 A1**

(12) **EUROPEAN PATENT APPLICATION**
published in accordance with Art. 153(4) EPC

(43) Date of publication:
**31.12.2025 Bulletin 2026/01**

(21) Application number: **24760132.1**

(22) Date of filing: **07.02.2024**

(51) International Patent Classification (IPC):
*H02J 7/00* (2006.01)     *H01M 10/48* (2006.01)

(52) Cooperative Patent Classification (CPC):
**H01M 10/48; H02J 7/00**

(86) International application number:
**PCT/JP2024/004125**

(87) International publication number:
**WO 2024/176830 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.02.2023 JP 2023025046**

(71) Applicant: **Panasonic Intellectual Property Management Co., Ltd.**
**Kadoma-shi, Osaka 571-0057 (JP)**

(72) Inventor: **MATSUDA, Takashi**
**Kadoma-shi, Osaka 571-0057 (JP)**

(74) Representative: **Novagraaf International SA Chemin de l'Echo 3**
**1213 Onex, Geneva (CH)**

(54) **DETERIORATION SUPPRESSION SYSTEM, DETERIORATION SUPPRESSION METHOD, DETERIORATION SUPPRESSION PROGRAM, AND STORAGE MEDIUM HAVING DETERIORATION SUPPRESSION PROGRAM WRITTEN THEREIN**

(57)     A histogram generation unit generates a histogram of a residence time of a state of charge (SOC) of a battery based on battery data. An actual SOC range calculation unit specifies, as an actual SOC use range, an SOC range that falls within a predetermined appearance probability from the histogram. A recommended SOC range calculation unit calculates a recommended SOC use range in which deterioration is further suppressed than the actual SOC use range while referring to deterioration characteristics of the battery based on the actual SOC use range and a statistical charge and discharge pattern based on the battery data. A charge recommendation degree generation unit generates the charge recommendation degree that increases or decreases in accordance with the SOC of the battery, the charge recommendation degree having a lower limit SOC of the recommended SOC use range as a charge start recommendation value and an upper limit SOC of the recommended SOC use range as a charge end recommendation value.

FIG. 2

**Description**

**TECHNICAL FIELD**

The present disclosure relates to a deterioration suppression system, a deterioration suppression method, a deterioration suppression program, and a storage medium for suppressing deterioration of a battery.

**BACKGROUND ART**

In recent years, with an increase in a capacity of a battery, there is no need to constantly charge a device on which a rechargeable battery is mounted to full charge depending on a use method of a user. In addition, the battery is increasingly used without charging every day. Accordingly, a method for suppressing deterioration by limiting a state of charge (SOC) of a battery has become easy to be effectively applied. In order to set the battery to last longer, it is desired to charge the battery in a planned manner as much as necessary.

However, a timing of charging depends on a lifestyle of each user. It is required to fill a difference between an SOC at the start or end of charging that contributes to deterioration suppression and an SOC at the start or end of charging actually by each user. In addition, it is also required to fill a gap (semantic gap) between a sensuous remaining battery level of each user and an actual remaining battery level. The semantic gap occurs in a device such as an EV, a smartphone, or a PC in which a charging work is performed based on a user's determination.

PTL 1 discloses a method for performing charge control to such an extent that a driver does not become concerned by detecting a situation in which a driver's face is captured and a remaining level of a display is viewed and an operation of searching for a charging station with a car navigation system and charging the battery until an SOC becomes slightly higher than an SOC in which the driver is concerned about the remaining level. This method suppresses deterioration of the battery by not setting the SOC as high as possible. In this method, a camera for monitoring the driver is required, and the system becomes large. In addition, when the SOC becomes more than or equal to a certain level, since charging is automatically stopped, the driver does not have a final selection right.

PTL 2 discloses a method for calculating an SOC range optimum for deterioration suppression of a power storage apparatus and displaying the calculated SOC range together with an SOC of the power storage apparatus. The SOC range optimum for deterioration suppression is displayed, and thus, the user is urged to perform charging optimum for deterioration suppression. However, many users ignore only the display of the optimum SOC range. In addition, the display of the optimum SOC range does not contribute to the elimination of the semantic gap.

Citation List

Patent Literatures

PTL 1: Unexamined Japanese Patent Publication No. 2022-035232
PTL 2: Unexamined Japanese Patent Publication No. 2021-083187

**SUMMARY OF THE INVENTION**

The present disclosure has been made in view of such a situation, and an object of the present disclosure is to provide a technology capable of bringing a charging timing of a user closer to a charging timing optimum for deterioration suppression in a naturally induced manner.

In order to solve the above problem, a deterioration suppression system according to one aspect of the present disclosure includes a histogram generation unit that generates a histogram of a residence time of a state of charge (SOC) of a battery based on battery data, an actual SOC range calculation unit that specifies, as an actual SOC use range, an SOC range that falls within a predetermined appearance probability from the histogram, a recommended SOC range calculation unit that calculates a recommended SOC use range in which deterioration is further suppressed than the actual SOC use range based on the actual SOC use range and a statistical charge and discharge pattern based on the battery data while referring to deterioration characteristics of the battery, and a charge recommendation degree generation unit that generates a charge recommendation degree that increases or decreases in accordance with the SOC of the battery, the charge recommendation degree having a lower limit SOC of the recommended SOC use range as a charge start recommendation value and an upper limit SOC of the recommended SOC use range as a charge end recommendation value.

Any combinations of configuration elements described above and expressions of the present disclosure that are converted in terms of devices, systems, methods, computer programs, recording media, and the like are also effective as aspects of the present disclosure.

According to the present disclosure, it is possible to bring the charging timing of the user closer to the charging timing optimum for deterioration suppression in the naturally induced manner.

**BRIEF DESCRIPTION OF THE DRAWINGS**

Fig. 1 is a diagram for explaining a battery-mounted device according to an exemplary embodiment.
Fig. 2 is a diagram illustrating functional blocks of a controller and a storage of the battery-mounted device in Fig. 1.
Fig. 3 is a diagram illustrating an example of a histogram of an SOC residence time.
Fig. 4A is a diagram illustrating a schematic example of a storage deterioration characteristic map.
Fig. 4B is a diagram illustrating a schematic example of a charge deterioration characteristic map.
Fig. 4C is a diagram illustrating a schematic example of a discharge deterioration characteristic map.
Fig. 5 is a diagram illustrating a display example of a charge recommendation degree.
Fig. 6 is a diagram illustrating a display example of an individually-adopted charge recommendation degree.
Fig. 7 is a diagram illustrating time-series display example 1 of the charge recommendation degree.
Fig. 8 is a diagram illustrating time-series display example 2 of the charge recommendation degree.
Fig. 9 is a flowchart illustrating a basic flow of display processing of the charge recommendation degree.

DESCRIPTION OF EMBODIMENT

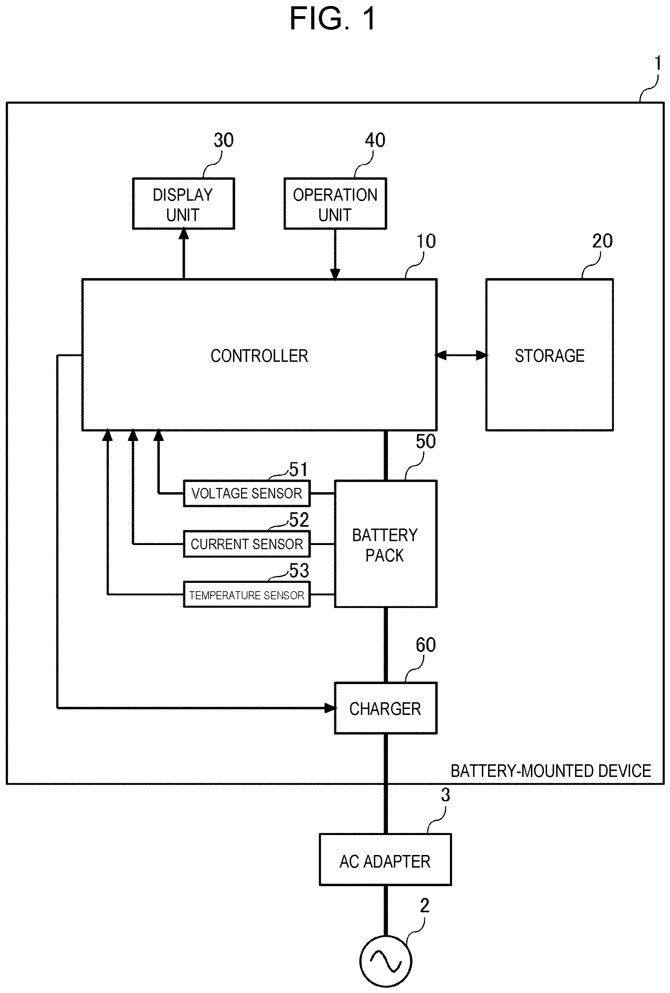

Fig. 1 is a diagram for explaining battery-mounted device 1 according to an exemplary embodiment. Battery-mounted device 1 according to the exemplary embodiment is a device on which chargeable and dischargeable battery pack 50 is mounted. Examples of battery-mounted device 1 include a portable information terminal (for example, a smartphone, a tablet, or a notebook PC), some home electric appliances (for example, a cleaning robot), an electric vehicle, an electric motorcycle, an electric bicycle, an electric kick scooter, a multi-copter (drone), and the like. Hereinafter, in the present exemplary embodiment, a smartphone is assumed.

Battery-mounted device 1 includes controller 10, storage 20, display unit 30, operation unit 40, battery pack 50, voltage sensor 51, current sensor 52, temperature sensor 53, and charger 60. Battery pack 50 is formed by connecting a plurality of cells or a plurality of parallel cell blocks in series. Each parallel cell block is formed by connecting a plurality of cells in parallel. For each of the cells, a lithium-ion battery cell, a nickel metal hydride battery cell, a lead battery cell, or the like can be used. Hereinafter, the present description assumes an example of use of lithium-ion battery cells (nominal voltage: 3.6 V to 3.7 V).

Voltage sensor 51 detects voltages of cells connected in series or parallel cell blocks. Current sensor 52 detects a current flowing through the cell or the parallel cell block connected in series based on a voltage across a shunt resistor. The plurality of cells or the plurality of parallel cell blocks connected in series are connected to the shunt resistor in series. Instead of the shunt resistor, a Hall element may be used. Temperature sensor 53 detects temperatures of the plurality of cells or the parallel cell blocks based on a divided voltage of a thermistor and a resistor installed in at least one of the plurality of cells or the parallel cell blocks. The voltages detected by voltage sensor 51, the currents detected by current sensor 52, and the temperatures detected by temperature sensor 53 are output to controller 10.

Controller 10 integrally controls entire battery-mounted device 1. Functions of controller 10 can be achieved by cooperation of a hardware resource and a software resource, or by the hardware resource alone. Available examples of the hardware resource include a CPU, a ROM, a RAM, a graphics processing unit (GPU), an application specific integrated circuit (ASIC), a field programmable gate array (FPGA), and other LSI circuits. As the software resource, an operating system, an application, and another program can be used.

Storage 20 includes a nonvolatile recording medium (NAND flash memory or the like) and stores various kinds of data. Display unit 30 includes a liquid crystal display, an organic EL display, a mini LED display, and the like, and displays an image supplied from controller 10. Operation unit 40 includes a physical button and a touch panel, receives an operation of a user, and outputs an operation signal based on an operation content to controller 10. A touch panel display in which functions of display unit 30 and operation unit 40 are integrated may be used. The program may be recorded in a recording medium. When this recording medium is used, the program can be installed in the computer, for example. Here, the recording medium on which the program is recorded may be a non-transitory recording medium. Although the non-transitory recording medium is not particularly limited, it may be a recording medium such as a CD-ROM, for example.

Battery pack 50 can be charged from commercial power system 2. A charge terminal of battery pack 50 is connected to commercial power system 2 via charger 60 and AC adapter 3. AC adapter 3 converts an AC voltage of 100/200 V input from commercial power system 2 into a DC voltage of about 5 V to 12 V, and outputs the DC voltage. In a case where battery-mounted device 1 is a notebook PC, AC adapter 3 converts the AC voltage into a DC voltage of about 14 V to 20 V and outputs the DC voltage.

Charger 60 includes a DC/DC converter. The DC/DC converter (for example, a switching regulator) controls a current or a voltage of a DC power supplied from AC adapter 3 according to a current command value or a voltage command value supplied from controller 10, and outputs the DC power of the current or the voltage specified by the command value to battery pack 50.

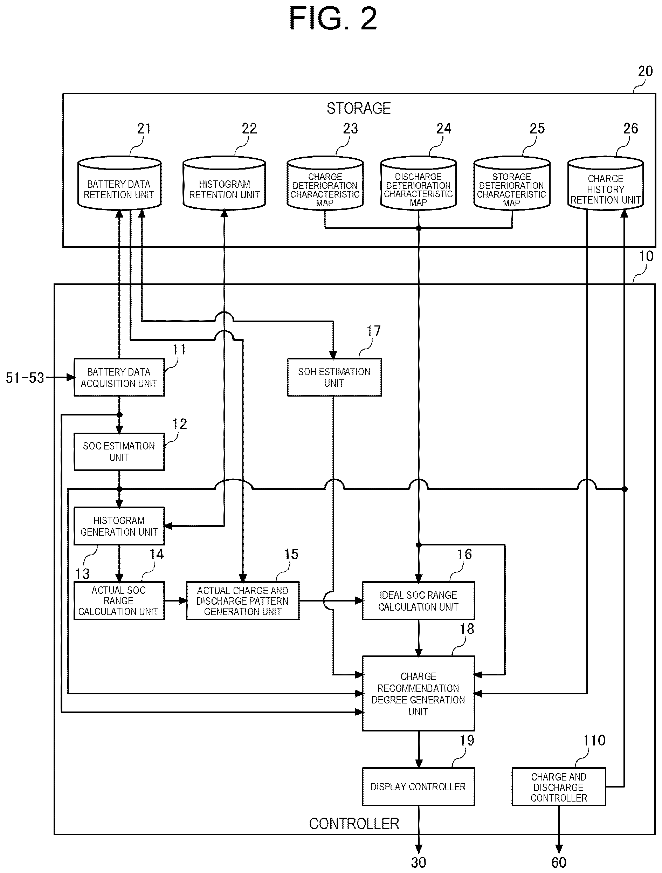

Fig. 2 is a diagram illustrating functional blocks of controller 10 and storage 20 of battery-mounted device 1 of Fig. 1. The functional blocks illustrated in Fig. 2 depict only functional blocks related to a deterioration suppression system of battery pack 50 according to the present exemplary embodiment. Controller 10 includes battery data acquisition unit 11, an SOC estimation unit 12, histogram generation unit 13, actual SOC range calculation unit 14, actual charge and discharge pattern generation unit 15, ideal SOC range calculation unit 16, state of health (SOH) estimation unit 17, charge recommendation degree generation unit 18, display controller 19, and charge and discharge controller 110. Storage 20 includes battery data retention unit 21, histogram retention unit 22, charge deterioration characteristic map 23, discharge deterioration characteristic map 24, storage deterioration characteristic map 25, and charge history retention unit 26.

Battery data acquisition unit 11 acquires battery data including a voltage, a current, and a temperature of each cell or each parallel cell block included in battery pack 50 from voltage sensor 51, current sensor 52, and temperature sensor 53 at a predetermined sampling cycle (for example, every 10 seconds, every 1 minute).

SOC estimation unit 12 estimates an SOC by a combination of an open circuit voltage (OCV) method and a current integration method. The OCV method is a method for estimating the SOC based on an OCV of each cell or each parallel cell block measured by voltage sensor 51 and an SOC-OCV curve of the cell. The SOC-OCV curve of the cell is created in advance based on a characteristic test by a battery manufacturer, and is registered in the ROM of controller 10 at the time of shipment.

The current integration method is a method for estimating the SOC based on an OCV at the start of charge and discharge of each cell and an integrated value of the currents measured by current sensor 52. The current integration method causes a measurement error of current sensor 52 to accumulate as charge and discharge times increase. On the other hand, the OCV method is affected by a measurement error of voltage sensor 51 and an error due to a polarization voltage. Thus, it is preferable to use a weighted average of the SOC estimated by the current integration method and the SOC estimated by the OCV method.

SOC estimation unit 12 estimates the SOC of battery pack 50 based on the SOC of each cell or each parallel cell block. Battery data acquisition unit 11 accumulates the battery data including the voltage, the current, the temperature, and the SOC of each cell or each parallel cell block in battery data retention unit 21. At this time, battery data acquisition unit 11 may accumulate only a maximum temperature and a minimum temperature among a plurality of temperatures measured by a plurality of temperature sensors 53 installed in battery pack 50. Battery data acquisition unit 11 may accumulate both the SOCs of all the cells or the parallel cell blocks and the SOC of entire battery pack 50, or may accumulate only the SOC of entire battery pack 50.

Histogram generation unit 13 creates a histogram of a residence time of the SOC of battery pack 50. Histogram generation unit 13 generates a histogram of a residence time for each SOC (for example, 1% increments or 5% increments). The histogram reflects a use state of battery pack 50 of the user. Histogram generation unit 13 may create a histogram of the SOC for the entire period from the start of use of battery pack 50, or may create a histogram of the SOC for a latest predetermined period (for example, 30 days). In the latter case, unnecessary battery data may be deleted as appropriate.

Histogram generation unit 13 may generate the histogram of the SOC residence time for each weekday and holiday or for each day of the week. In addition, histogram generation unit 13 may generate a histogram in which data is weighted such that a weight of data closest to latest data increases. Histogram generation unit 13 stores the generated histogram in histogram retention unit 22.

Actual SOC range calculation unit 14 fits the histogram of the SOC residence time by using a Gaussian function, and specifies an SOC range that falls within a predetermined appearance probability as an actual SOC use range. For example, actual SOC range calculation unit 14 specifies an SOC range that falls within a range of $u \pm k\sigma$ as the actual SOC use range. In a case where k is a constant, and for example, k = 2 is set, an SOC range in which about 95% of the SOC falls can be specified. Since data near SOC = 100% and data near SOC = 0% may be left for a long period, it is preferable to exclude the data from a target when the histogram is fitted to a normal distribution.

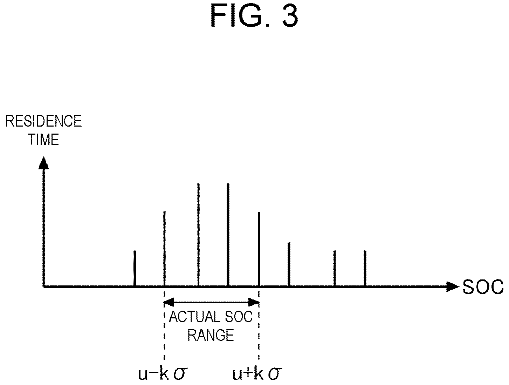

Fig. 3 is a diagram illustrating an example of the histogram of the SOC residence time. A horizontal axis represents SOC "%", and a vertical axis represents a residence time [h]. Actual SOC range calculation unit 14 fits the histogram by using the Gaussian function, and specifies the SOC range that falls within the range of $u \pm k\sigma$ as the actual SOC use range.

The description refers back to Fig. 2. Actual charge and discharge pattern generation unit 15 acquires battery data of a target period corresponding to a histogram generation period of the SOC residence time from battery data retention unit 21. Actual charge and discharge pattern generation unit 15 generates an actual charge and discharge pattern based on current data in the target period. In the present exemplary embodiment, the actual charge and discharge pattern refers to a statistical charge and discharge pattern of one cycle including a charge period and a discharge period.

Actual charge and discharge pattern generation unit 15 calculates an average value of charge times. The average value is a representative value of the charge times, and a median value or a mode value may be used instead of the average value. Actual charge and discharge pattern generation unit 15 calculates an average value of charge intervals. The charge interval refers to a period from the end of a certain charge to the start of the next charge. Actual charge and discharge pattern generation unit 15 sets a period obtained by adding an average charge time and an average charge interval as a period of the actual charge and discharge pattern. Histogram generation unit 13 may calculate a weighted average value of the charge time and a weighted average value of the charge interval such that the weight of the data closest to the latest data increases, and may add the weighted average value and the weighted average value to set the period of the actual charge and discharge pattern. In this case, a more recent use tendency can be reflected.

Actual charge and discharge pattern generation unit 15 assumes that a power amount corresponding to a depth of discharge (DOD) in the actual SOC use range is charged in every charge and that the power amount is charged at a constant current in a charge period of the actual charge and discharge pattern, and generates a current pattern in the charge period of the actual charge and discharge pattern. Actual charge and discharge pattern generation unit 15 assumes that the power amount is discharged at a constant current in one charge interval, and generates a current pattern in a non-charge period (combination of a discharge period and a pausing period) of the actual charge and discharge pattern.

In a case where the current pattern in the charge period can be extracted from past battery data, actual charge and discharge pattern generation unit 15 may use the extracted current pattern as the current pattern in the charge period of the actual charge and discharge pattern. Similarly, in a case where a current pattern in the non-charge period in the actual charge and discharge pattern can be extracted from the past battery data, actual charge and discharge pattern generation unit 15 may use the extracted current pattern as the current pattern in the non-charge period of the actual charge and discharge pattern. For example, in the case of timer type battery-mounted device 1, when the charge period is excluded, the battery is basically discharged in a set time zone, and the remaining time zone is paused. In this case, actual charge and discharge pattern generation unit 15 can clearly divide the current pattern in the non-charge period in the actual charge and discharge pattern into the discharge period and the pause period.

Charge deterioration characteristic map 23, discharge deterioration characteristic map 24, and storage deterioration characteristic map 25 are obtained by mapping charge deterioration characteristics, discharge deterioration characteristics, and storage deterioration characteristics of the cells included in battery pack 50. The charge deterioration characteristics, the discharge deterioration characteristics, and the storage deterioration characteristics of the cells are derived in advance by experiments and simulations by battery manufacturers. Data derived from other evaluation organizations may be used.

Storage deterioration is deterioration that progresses over time in accordance with a temperature at each time point and an SOC at each time point of the cell. The storage deterioration progresses as time goes, regardless of whether or not charge or discharge is being performed. The storage deterioration mainly occurs due to formation of a solid electrolyte interphase (SEI) film on a negative electrode. The storage deterioration depends on the SOC and temperature at each time point. In general, the higher the SOC at each time point is or the higher the temperature at each time point is, the more a storage deterioration rate increases.

Charge and discharge deterioration is deterioration that progresses with increase in a number of times of charging and discharging. The charge and discharge deterioration mainly occurs due to cracking or peeling by expansion or contraction of an active material. The charge and discharge deterioration depends on a current rate, an SOC range to be used, and a temperature. In general, the higher the current rate is, the wider the SOC range to be used is, and the higher the temperature is, the more a charge and discharge deterioration rate increases.

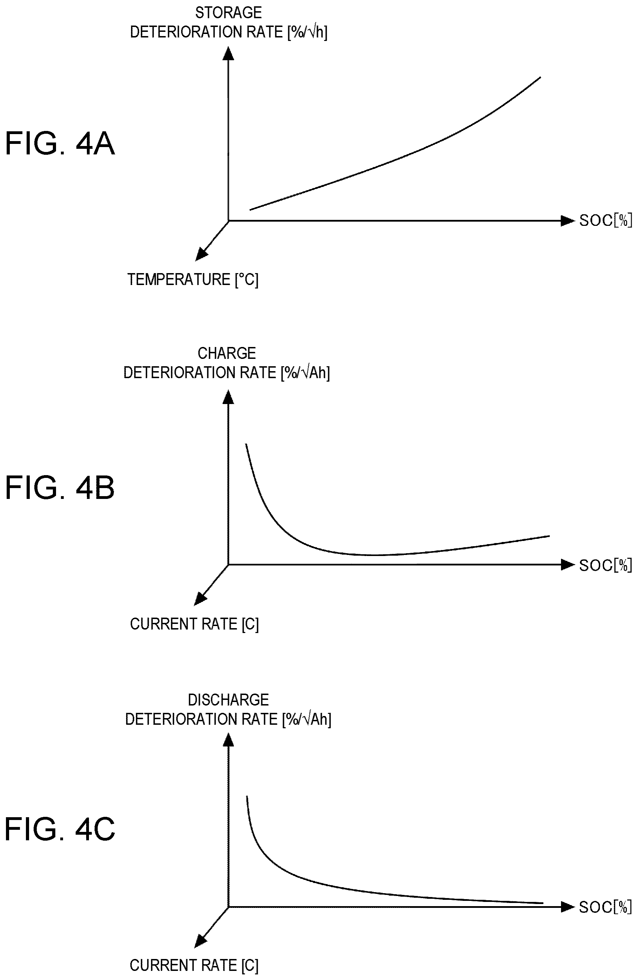

Figs. 4A to 4C are diagrams showing schematic examples of the storage deterioration characteristic map, the charge deterioration characteristic map, and the discharge deterioration characteristic map. Fig. 4A illustrates a schematic example of the storage deterioration characteristic map. An X-axis represents an SOC [%], a Y-axis represents a temperature [°C], and a Z-axis represents a storage deterioration rate [%/$\sqrt{h}$]. In general, the storage deterioration progresses substantially linearly with respect to a value obtained by raising elapsed time (h) to the power of 0.5 (square root). Depending on a type of the cell, elapsed time (h) may progress substantially linearly with respect to a value obtained by raising elapsed time (h) to the power of 0.4, a value obtained by raising elapsed time (h) to the power of 0.6, or the like. As illustrated in Fig. 4A, the higher the SOC is, the faster the storage deterioration rate becomes.

Fig. 4B illustrates a schematic example of the charge deterioration characteristic map. An X-axis represents an SOC use range [%], a Y-axis represents a current rate [C], and a Z-axis represents a charge deterioration rate [%/$\sqrt{Ah}$]. Fig. 4C illustrates a schematic example of the discharge deterioration characteristic map. An X-axis represents an SOC use range [%], a Y-axis represents a current rate [C], and a Z-axis represents a discharge deterioration rate [%/$\sqrt{Ah}$]. In general, the charge and discharge deterioration progresses substantially linearly with respect to a value obtained by raising total charge amount or total discharge amount (Ah) to the power of 0.5 (square root). Depending on the type of the cell, charge amount or discharge amount (Ah) may progress substantially linearly with respect to a value obtained by raising total charge amount or total discharge amount (Ah) to the power of 0.4 or a value obtained by raising total charge amount or total discharge amount (Ah) to the power of 0.6.

As illustrated in Fig. 4B, charging in a low SOC region increases the charge deterioration rate. In addition, in the case of charging in a high SOC region, the charge deterioration rate becomes faster, although not as much as in the low SOC region. In addition, as illustrated in Fig. 4C, the discharge deterioration rate increases as the discharge is performed in a region where the SOC is low.

The charge and discharge deterioration characteristics do not contribute as much as the current rate does, but are also affected by temperature. Thus, in order to raise the estimation accuracy of the charge and discharge deterioration rate, it is preferable to prepare charge and discharge deterioration characteristics in which a relationship between the SOC use range and the charge and discharge deterioration rate is defined for each two-dimensional combination of a plurality of current rates and a plurality of temperatures. On the other hand, in a case where a simple charge and discharge deterioration characteristic map is generated, the temperature is regarded as a normal temperature, and charge and discharge deterioration characteristics for each of a plurality of current rates need only be prepared. The storage deterioration characteristics, the charge deterioration characteristics, and the discharge deterioration characteristics may be defined by a function instead of a map.

The description refers back to Fig. 2. Ideal SOC range calculation unit 16 searches for an SOC use range (hereinafter, referred to as an ideal SOC use range) having the same DOD as the actual SOC use range and a lowest deterioration while referring to charge deterioration characteristic map 23, discharge deterioration characteristic map 24, and storage deterioration characteristic map 25 based on the actual SOC use range and the actual charge and discharge pattern. For example, ideal SOC range calculation unit 16 shifts the actual SOC use range in predetermined increments (for example, 5% increments or 1% increments), and calculates a deterioration amount in a case where charging and discharging of the actual charge and discharge pattern are performed in each SOC use range. Ideal SOC range calculation unit 16 determines the SOC range with a smallest deterioration amount as the ideal SOC use range. The ideal SOC use range indicates an optimum SOC use range of battery pack 50 to be recommended to the user.

SOH estimation unit 17 estimates an SOH of battery pack 50. For example, SOH estimation unit 17 calculates a difference (depth of discharge DOD) between an SOC corresponding to the OCV at the start of charging and an SOC corresponding to the OCV at the end of charging, and calculates current integration value $\Sigma I$ during the charge period.

SOH estimation unit 17 estimates a full charge capacity (FCC) based on depth of discharge DOD and current integration value $\Sigma I$ as expressed in the following (Expression 1). SOH estimation unit 17 estimates an SOH based on the estimated FCC and an initial FCC as expressed in the following (Expression 2). The SOH is defined as a ratio of a current FCC to the initial FCC, and a lower value (closer to 0%) indicates that deterioration has progressed more.

$$FCC = \Sigma I/DOD \ ... \ (\text{Expression } 1)$$

$$SOH = \text{Current FCC/Initial FCC} \ ... \ (\text{Expression } 2)$$

Charge recommendation degree generation unit 18 generates a charge recommendation degree that increases or decreases in accordance with the SOC of battery pack 50, and the charge recommendation degree has a lower limit SOC of the ideal SOC use range generated by ideal SOC range calculation unit 16 as a charge start recommendation value and an upper limit SOC as a charge end recommendation value. The charge recommendation degree is not an index indicating the SOC of battery pack 50 as it is, but is a unique index customized based on a use history of the user or the like.

Display controller 19 displays, on display unit 30, the charge recommendation degree generated by charge recommendation degree generation unit 18 and at least one of the charge start recommendation value or the charge end recommendation value. For example, display controller 19 can display the charge recommendation degree in accordance with a bar that expands or contracts in accordance with the SOC of battery pack 50. At that time, display controller 19 can display at least one of the charge start recommendation value or the charge end recommendation value, as a scale at a predetermined position in an expansion and contraction range of a recommendation degree bar.

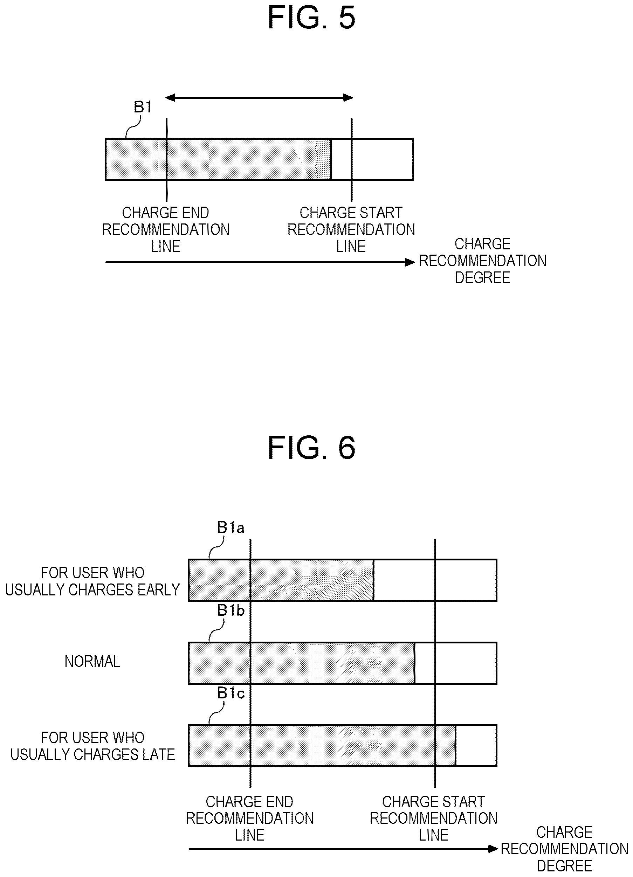

Fig. 5 is a diagram illustrating a display example of the charge recommendation degree. In the example illustrated in Fig. 5, the charge recommendation degree is displayed as recommendation degree bar B1 that expands and contracts in a left-right direction. As described above, since recommendation degree bar B1 does not display the SOC of battery pack 50 itself, recommendation degree bar B1 is displayed separately from normal display of a remaining battery level.

In Fig. 5, as recommendation degree bar B1 expands to the right, the charge recommendation degree becomes higher, and as recommendation degree bar B1 contracts to the left, the charge recommendation degree becomes lower. On recommendation degree bar B1, a charge start recommendation line depicting the charge start recommendation value by a scale and a charge end recommendation line indicating the charge end recommendation value by a scale are displayed. Positions of the charge start recommendation line and the charge end recommendation line on recommendation degree bar B1 are basically fixed. For example, the charge start recommendation line may be drawn at a position of 80% of the entire length of recommendation degree bar B1, and the charge end recommendation line may be drawn at a position of 20%.

Display controller 19 may not constantly display both the charge start recommendation line and the charge end recommendation line. For example, display controller 19 may display only the charge start recommendation line while battery-mounted device 1 is in use, and may display only the charge end recommendation line while battery-mounted device 1 is being charged.

When battery pack 50 is charged, charge and discharge controller 110 sets a current command value or a voltage command value in charger 60 based on predetermined charging plan to control charging. In a case where a battery protection mode is selected by the user in advance in the mode setting of the battery, charge and discharge controller 110 automatically stops charging at a point in time when the charge recommendation degree reaches the charge end recommendation value while battery pack 50 is being charged. In a case where a normal mode is selected in the mode setting of the battery, charge and discharge controller 110 does not stop charging even though the charge recommendation degree reaches the charge end recommendation value.

Charge recommendation degree generation unit 18 converts the movement of the SOC within the ideal SOC range of battery pack 50 into the movement of the charge recommendation degree in a range between the charge start recommendation value and the charge end recommendation value in the recommendation degree display. Charge recommendation degree generation unit 18 converts the movement of the SOC in a range from SOC = 0% to the lower limit SOC of the ideal SOC range into the movement of the charge recommendation degree in a range from the upper limit (right end in Fig. 5) of the charge recommendation degree to the charge start recommendation value in the recommendation degree display. Charge recommendation degree generation unit 18 converts the movement of the SOC in the range from the upper limit SOC of the ideal SOC range to SOC = 100% into the movement of the charge recommendation degree in the range from the charge end recommendation value in the recommendation degree display to the lower limit (the left end in Fig. 5) of the charge recommendation degree.

Charge recommendation degree generation unit 18 can adjust a change rate of the charge recommendation degree. Charge recommendation degree generation unit 18 can add or subtract an offset to or from the charge recommendation degree. In a case where it is desired to advance a charge start timing of the user during a period in which battery-mounted device 1 is not charged, charge recommendation degree generation unit 18 increases an increase rate of the charge recommendation degree or adds the offset to the charge recommendation degree. Conversely, in a case where it is desired to delay the charge start timing of the user, charge recommendation degree generation unit 18 delays the increase rate of the charge recommendation degree or subtracts the offset from the charge recommendation degree.

Charge recommendation degree generation unit 18 increases a decrease rate of the charge recommendation degree or subtracts the offset from the charge recommendation degree in a case where it is desired to advance a charge end timing of the user during the period in which battery-mounted device 1 is being charged. Conversely, in a case where it is desired to delay the charge end timing of the user, charge recommendation degree generation unit 18 delays the decrease rate of the charge recommendation degree or adds the offset to the charge recommendation degree.

Charge recommendation degree generation unit 18 can estimate a deterioration amount in the case of charging at the current temperature while referring to charge deterioration characteristic map 23 based on a current temperature of battery pack 50. In a case where the deterioration amount in the case of charging at an estimated current temperature is more than or equal to a threshold, charge recommendation degree generation unit 18 delays the increase rate of the charge recommendation degree or subtracts the offset from the charge recommendation degree. In a case where battery-mounted device 1 is an EV, when heat is generated immediately after traveling or an outside temperature is low, the deterioration amount is easy to be more than or equal to the threshold. The control of the recommendation degree display based on the current temperature is performed during a period in which battery-mounted device 1 is not charged.

As described above, the charge deterioration rate depends on a current rate, an SOC range to be used, and a temperature. Charge recommendation degree generation unit 18 sets a charge rate of a charging device to the current rate, sets the ideal SOC range to the SOC range to be used, sets the current temperature of battery pack 50 to the temperature, and derives the charge deterioration rate (hereinafter, considered as a charge deterioration amount) while referring to charge deterioration characteristic map 23. Charge recommendation degree generation unit 18 may derive the deterioration amount in a case where the maximum temperature of battery pack 50 is set and the deterioration amount when the minimum temperature of battery pack 50 is set.

In a case where the charge deterioration amount is more than or equal to the threshold, charge recommendation degree generation unit 18 delays the increase rate of the charge recommendation degree or subtracts the offset from the charge recommendation degree to delay the charge start timing by the user until the temperature changes to a temperature at which a burden on battery pack 50 is alleviated. At that time, charge recommendation degree generation unit 18 further delays the increase rate or subtracts a larger offset from the charge recommendation degree as a deviation in which the charge deterioration amount exceeds the threshold is larger. When the actual SOC of battery pack 50 reaches a lower limit set value (for example, 5%), charge recommendation degree generation unit 18 increases the charge recommendation degree to the charge start recommendation value.

Charge recommendation degree generation unit 18 may specify the number of times of rapid charging while referring to current data in a latest predetermined period (for example, past one month), and may delay the increase rate of the charge recommendation degree or may subtract the offset from the charge recommendation degree in a case where the number of times of rapid charging is more than or equal to a threshold.

In order to prevent minute shortening of the cells in battery pack 50, there is a battery pack 50 in which control is performed to decrease a full-charge voltage as the SOH decreases. In such battery pack 50, as the SOH of battery pack 50 is lower, charge recommendation degree generation unit 18 can increase the change rate of the charge recommendation degree, or add or subtract the large offset to or from the charge recommendation degree.

For example, charge recommendation degree generation unit 18 retains in advance an SOH-full-charge voltage table (not illustrated) of battery pack 50, and specifies the current full-charge voltage while referring to the SOH-full-charge voltage table based on a current SOH. Charge recommendation degree generation unit 18 increases the change rate of the charge recommendation degree, or adds or subtracts the larger offset to or from the charge recommendation degree such that reduction in a voltage use range is offset as a reduction rate of a current voltage use range with respect to an initial voltage use range increases. Charge recommendation degree generation unit 18 adds the offset during the period in which battery-mounted device 1 is not charged, and subtracts the offset during a period in which battery-mounted device 1 is charged.

In a case where SOC estimation unit 12 specifies the current full-charge voltage based on the current SOH while referring to the SOH-full-charge voltage table, calculates the reduction rate of the current voltage use range with respect to the initial voltage use range, and reduces the SOC use range in accordance with the reduction rate to generate the SOC, charge recommendation degree generation unit 18 does not need to adjust the change rate or the offset of the charge recommendation degree.

Charge history retention unit 26 retains a history of the SOC at the start and the SOC at the end of charging of battery pack 50 by the user. Charge and discharge controller 110 stores the SOC at a timing when the charging of battery pack 50 is started (for example, a timing at which a charging cable is connected to battery-mounted device 1) in charge history retention unit 26. In addition, charge and discharge controller 110 stores the SOC at the timing when the charging of battery pack 50 is started (for example, a timing at which the charging cable is removed from battery-mounted device 1 and a timing at which the voltage reaches a predetermined charge end voltage) in charge history retention unit 26.

Charge recommendation degree generation unit 18 changes the change rate of the charge recommendation degree based on a difference between a statistical value of the SOC at the start of charging and the charge start recommendation value accumulated in charge history retention unit 26 to reduce the difference, or changes the offset to be added to or subtracted from the charge recommendation degree. In the case of a user who usually has a strong tendency to start charging before the charge recommendation degree exceeds the charge start recommendation value, charge recommendation degree generation unit 18 delays the increase rate of the charge recommendation degree. On the other hand, in the case of a user who has a strong tendency to start charging after the charge recommendation degree exceeds the charge start recommendation value, charge recommendation degree generation unit 18 increases the increase rate of the charge recommendation degree.

Hereinafter, an example of a specific method for changing the increase rate or the offset of the charge recommendation degree will be described. Charge recommendation degree generation unit 18 calculates the following (Expression 3) to calculate average difference ave.

$$\text{ave} = \Sigma\,(\text{Charge start recommendation value} - \text{SOC at actual charge start})/n \ ...$$

(Expression 3)

n is the number of samples of the SOC at the actual charge start.

Instead of an average value of differences between the charge start recommendation value and the SOC at the actual charge start, a median or a mode of the differences may be used.

Charge recommendation degree generation unit 18 can calculate an increase rate of a charge recommendation degree customized for each user by multiplying a normal increase rate of the charge recommendation degree by a rate change coefficient based on average difference ave as expressed in the following (Expression 4).

Individually-adapted increase rate = Normal increase rate $\times$ Rate change coefficient ... (Expression 4)     (Expression 4)

Speed change coefficient = ave/Reference value

Charge recommendation degree generation unit 18 can calculate a charge recommendation degree customized for each user by adding average difference ave as the offset to a normal charge recommendation degree as expressed in the following (Expression 5).

Individually-adapted charge recommendation degree = Normal charge recommendation degree + ave ... (Expression 5) (Expression 5)

Charge recommendation degree generation unit 18 moves the charge recommendation degree at an individually-adapted increase rate or adds an individually-adapted offset to the charge recommendation degree in the range between the charge start recommendation value and the charge end recommendation value.

Based on a difference between the statistical value of the SOC at the end of charging and the charge end recommendation value accumulated in charge history retention unit 26, charge recommendation degree generation unit 18 changes the change rate of the charge recommendation degree to reduce the difference, or changes the offset to be added to or subtracted from the charge recommendation degree. In the case of a user who usually has a strong tendency to stop charging after the charge recommendation degree exceeds the charge end recommendation value, charge recommendation degree generation unit 18 increases the decrease rate of the charge recommendation degree. On the other hand, in the case of a user who has a strong tendency to stop charging before the charge recommendation degree exceeds the charge end recommendation value, charge recommendation degree generation unit 18 delays the decrease rate of the charge recommendation degree. As a specific method for changing the decrease rate or the offset of the charge recommendation degree, the method represented in the above (Expression 3) to (Expression 5) can be used. The SOC at the actual charge start may be read as the SOC at the actual charge end, and the increase rate of the charge recommendation degree may be read as the decrease rate of the charge recommendation degree.

Fig. 6 is a diagram illustrating a display example of the individually-adopted charge recommendation degree. Fig. 6 illustrates a display example of a non-charge period (that is, a period in which the charge recommendation degree increases). Recommendation degree bar B1a at the top shows a display example for a user who usually charges early. Recommendation degree bar B1b in the middle shows a normal display example. Recommendation degree bar B1c at the bottom shows a display example for a user who normally charges late.

For a user whose charge start timing is early, recommendation degree bar B1a is expanded to be late like recommendation degree bar B1a at the top, and thus, the user is urged to delay a timing to start charging naturally. On the other hand, for a user whose charge start timing is late, recommendation degree bar B1c at the bottom is expanded early like recommendation degree bar B1c, and thus, the user is urged to advance the timing to start charging naturally.

As for the charge period (that is, a period in which the charge recommendation degree decreases), for a user whose charge end timing is late, the recommendation degree bar is expanded early, and thus, the user is urged to advance a timing to end charging naturally. On the other hand, for a user whose charge end timing is early, the recommendation degree bar is expanded to be late, and thus, the user is urged to delay the timing to end charging naturally.

Although Figs. 5 and 6 illustrate display examples of an instantaneous value of the charge recommendation degree, time-series display of the charge recommendation degree in which the instantaneous value of the charge recommendation degree is displayed in time series is also possible. Charge recommendation degree generation unit 18 can predict future SOC transition based on SOC transition from a predetermined period before to the present of battery pack 50, and can predict future transition of the charge recommendation degree. Display controller 19 can display the prediction transition of the charge recommendation degree in time series.

Charge recommendation degree generation unit 18 calculates an inclination of the SOC during a target period based on a sampling value of the SOC in the target period from a predetermined period before to the present of battery pack 50. For example, charge recommendation degree generation unit 18 generates the regression line of the SOC during the target period and calculates the inclination of the SOC. As the target period is set to be shorter, the more recent the tendency can be reflected.

Charge recommendation degree generation unit 18 predicts the future SOC transition of battery pack 50 on the assumption that the calculated inclination of the SOC continues. Charge recommendation degree generation unit 18 calculates the prediction transition of the charge recommendation degree based on the prediction SOC transition of battery pack 50.

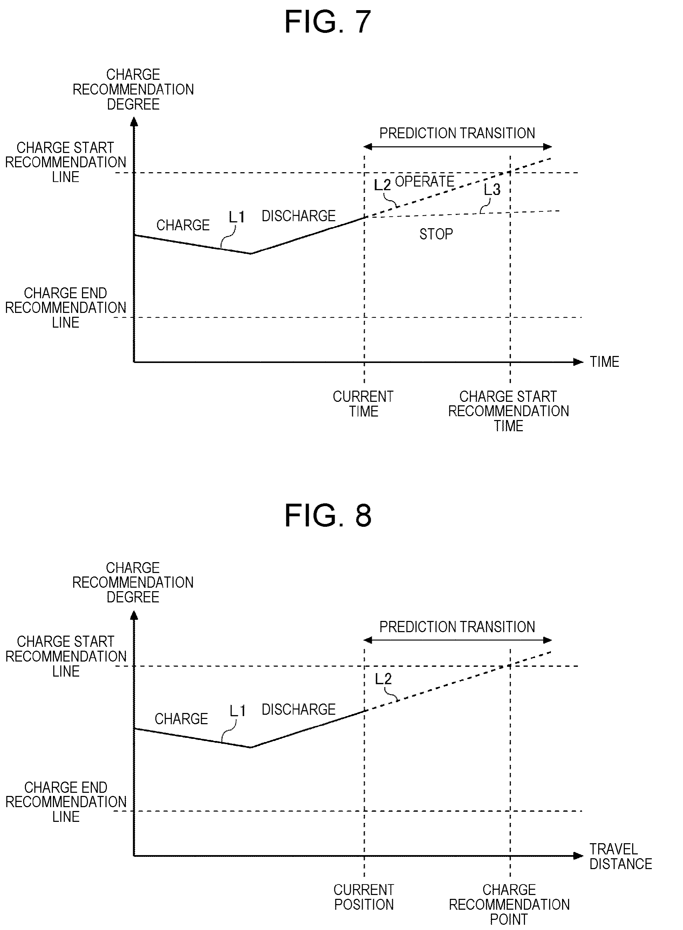

Fig. 7 is a diagram illustrating time-series display example 1 of the charge recommendation degree. A horizontal axis represents time, and a vertical axis represents the charge recommendation degree. Solid line L1 indicates a transition of the charge recommendation degree from a predetermined period before to the present. Thick dotted line L2 indicates a prediction transition of the charge recommendation degree in a case where an inclination of the current SOC continues. Thin dotted line L3 indicates a predicted transition of the charge recommendation degree in a case where an operation of battery-mounted device 1 is stopped. In a case where the operation of battery-mounted device 1 is stopped, thick dotted line L2 disappears and thin dotted line L3 is displayed. In a case where the inclination of the SOC changes, an inclination of thick dotted line L2 changes. The user can recognize a time to be charged next by viewing the time-series display of the charge recommendation degree.

Fig. 8 is a diagram illustrating time-series display example 2 of the charge recommendation degree. A horizontal axis indicates a travel distance, and a vertical axis indicates the charge recommendation degree. Time-series display example 2 is a display example in a case where battery-mounted device 1 is an EV. Charge recommendation degree generation unit 18 calculates a travel distance for a unit SOC change based on an SOC change amount during the target period from a predetermined period before to the present of battery pack 50 and a travel distance during the target period acquired from an odometer of a vehicle. Charge recommendation degree generation unit 18 predicts the future transition of the charge recommendation degree for the travel distance based on the travel distance for the unit SOC change and the prediction SOC transition of battery pack 50.

Charge recommendation degree generation unit 18 may cooperate with a car navigation system of the vehicle, and may specify a candidate for a charging station adjacent to an advanced charge recommendation point by a travel distance by which the charge recommendation degree reaches the charge start recommendation line from a current position. For example, display controller 19 may display three candidates for the charging station adjacent to the charge recommendation point in order of proximity to the charge recommendation point. In a case where the charging station is not present around the charge recommendation point and there is a risk of electricity shortage unless charging early, the charge recommendation line may be lowered to urge early charging.

According to time-series display example 2 of the charge recommendation degree illustrated in Fig. 8, the user (driver) can intuitively recognize at which point to charge while traveling, and it is easy to make a travel plan. The user can infer which driving behavior affects how the remaining battery level of battery pack 50 by viewing the time-series display of the charge recommendation degree illustrated in Fig. 8. That is, the time-series display example of the charge recommendation degree also has an effect of urging the user to change his or her behavior during next and subsequent driving.

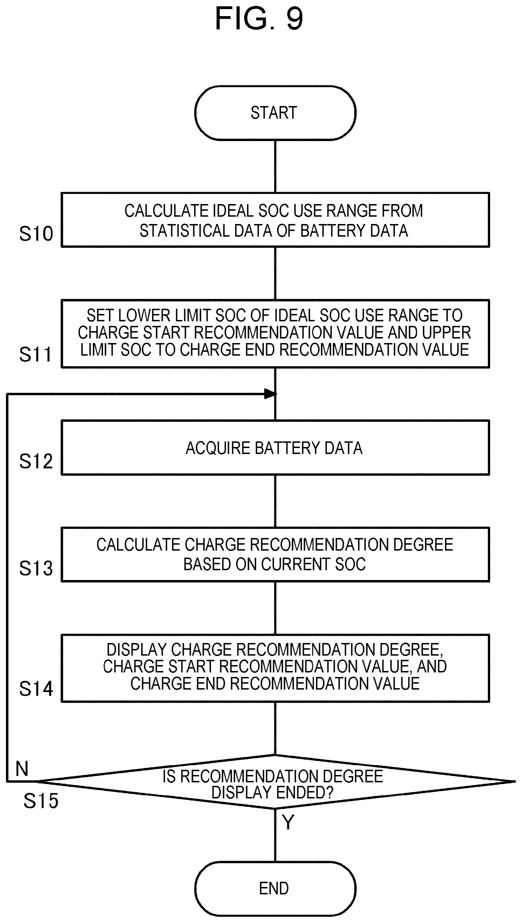

Fig. 9 is a flowchart illustrating a basic flow of display processing of the charge recommendation degree. Ideal SOC range calculation unit 16 calculates an ideal SOC range optimum for deterioration suppression from statistical data of the battery data (S10). Charge recommendation degree generation unit 18 sets the lower limit SOC of the ideal SOC use range to the charge start recommendation value, and sets the upper limit SOC to the charge end recommendation value (S11).

Battery data acquisition unit 11 acquires current battery data (S12). Charge recommendation degree generation unit 18 calculates the charge recommendation degree based on the current SOC of battery pack 50 (S13). Display controller 19 displays, on display unit 30, the charge recommendation degree, the charge start recommendation value, and the charge end recommendation value (S14). Processing from step S12 to step S14 is repeatedly executed (N in S15) until the display of the charge recommendation degree ends (Y in S15).

As described above, according to the present exemplary embodiment, the charge recommendation degree customized for each user is displayed, and thus, the user can perform charging in which deterioration is suppressed in a naturally induced manner even though the user does not have knowledge about battery deterioration. That is, the charging timing of the user can be brought close to a charging timing optimum for deterioration suppression. The display of the charge recommendation degree also contributes to filling a gap between a sensory remaining battery level of each user and the actual remaining battery level.

The user does not need to perform complicated setting in order to display the charge recommendation degree, and a burden on the user is basically not generated. The change rate of the charge recommendation degree is changed based on the temperature, the SOH, or the history of the charge start and end timings of the user, and thus, it is possible to calculate a more optimum charge recommendation degree reflecting environmental conditions or the tendency of the charging method of each user.

The present disclosure has been described above in accordance with the exemplary embodiment. It will be understood by the person of ordinary skill in the art that the exemplary embodiment is merely an example, other modified examples in which configuration elements and processing processes of the exemplary embodiment are variously combined are possible, and the other modified examples still fall within the scope of the present disclosure.

In Figs. 5 and 6, it has been described that display controller 19 displays the charge recommendation degree with the bar. In this regard, in a case where it is desired to reduce a display space, display controller 19 may display the charge recommendation degree as a numerical value. In a case where the charge recommendation degree exceeds the charge start recommendation value, or in a case where the charge recommendation degree falls below the charge end recommendation value, display controller 19 changes color of the numerical value to a conspicuous color (for example, red), or blinks the numerical value, for example.

In the above exemplary embodiment, it has been described that display controller 19 changes the change rate of the bar of the charge recommendation degree based on the temperature, the SOH, or the history of the charge start and end timings of the user. In this regard, display controller 19 may change the position of the charge start recommendation line or the charge end recommendation line without changing the bar change rate of the charge recommendation degree.

An audio notification unit (not illustrated) may output an alert sound or an audio message from a speaker in a vehicle interior at a timing when the charge recommendation degree reaches the charge start recommendation value or a timing when the charge recommendation degree reaches the charge end recommendation value. In a case where battery-mounted device 1 is an EV, an approach sound controller (not illustrated) may increase a volume or a frequency of the approach sound emitted from a vehicle speaker during traveling as the charge recommendation degree approaches the charge start recommendation value.

In the above exemplary embodiment, it has been described that battery-mounted device 1 executes the generation of the histogram, the generation of the ideal SOC use range, and the generation of the charge recommendation degree in an offline standalone configuration. In this regard, the deterioration suppression system may be constructed in an online configuration. In this case, battery-mounted device 1 is connected to a server via a network, and transmits the battery data from battery-mounted device 1 to the server. The server executes the generation of the histogram, the generation of the ideal SOC use range, and the generation of the charge recommendation degree based on the received battery data, and transmits the charge start recommendation value and the charge end recommendation value based on the ideal SOC use range, and the charge recommendation degree to battery-mounted device 1.

In the case of the online configuration, battery data acquisition unit 11, histogram generation unit 13, actual SOC range calculation unit 14, actual charge and discharge pattern generation unit 15, ideal SOC range calculation unit 16, SOH estimation unit 17, and charge recommendation degree generation unit 18 in Fig. 2 are provided on the server side. SOC estimation unit 12, display controller 19, and charge and discharge controller 110 are provided on battery-mounted device 1 side.

As described above, when the use state of battery pack 50 by the user is managed by the histogram, the average value of the charge times, and the average value of the charge intervals, an operation can be performed such that the histogram, the average value of the charge times, and the average value of the charge intervals are integrated by difference calculation. In this case, a retention amount of the battery data can be reduced. In addition, a calculation amount can also be reduced. Thus, the deterioration suppression method according to the present exemplary embodiment does not require a high-spec processor, and can be realized at low cost even in the offline standalone configuration.

The exemplary embodiment may be defined by the following items.

[Item 1]

Deterioration suppression system (10) including:

histogram generation unit (13) that generates a histogram of a residence time of a state of charge (SOC) of battery (50) based on battery data;

actual SOC range calculation unit (14) that specifies, as an actual SOC use range, an SOC range that falls within a predetermined appearance probability from the histogram;

recommended SOC range calculation unit (16) that calculates a recommended SOC use range in which deterioration is further suppressed than the actual SOC use range based on the actual SOC use range and a statistical charge and discharge pattern based on the battery data while referring to deterioration characteristics of battery (50); and

charge recommendation degree generation unit (18) that generates a charge recommendation degree that increases or decreases in accordance with the SOC of battery (50), the charge recommendation degree having a lower limit SOC of the recommended SOC use range as a charge start recommendation value and an upper limit SOC of the recommended SOC use range as a charge end recommendation value.

Accordingly, it is possible to generate a unique index to be presented to the user for bringing the charging timing of the user closer to the charging timing optimum for deterioration suppression.

[Item 2]

Deterioration suppression system (10) according to Item 1, further including display controller (19) that displays, on display unit (30), the charge recommendation degree and at least one of the charge start recommendation value or the charge end recommendation value.

Accordingly, the charging timing of the user can be brought close to the charging timing optimum for deterioration suppression in a naturally induced manner.

[Item 3]

Deterioration suppression system (10) according to Item 2, in which

display controller (19)

displays the charge recommendation degree by a bar that expands or contracts in accordance with the SOC of battery (50), and

displays, as a scale, the at least one of the charge start recommendation value or the charge end recommendation value at a predetermined position in an expansion and contraction range of the bar.

Accordingly, the charge end recommendation value is displayed by expansion and contraction of the bar, and thus, the charging timing of the user can be brought close to the charging timing optimum for deterioration suppression.

[Item 4]

Deterioration suppression system (10) according to Item 2, in which

charge recommendation degree generation unit (18) predicts future SOC transition based on SOC transition of battery (50) from a predetermined period before to a present, and predicts future transition of the charge recommendation degree, and

display controller (19) displays the future transition of the charge recommendation degree.

Accordingly, it is possible to present the optimum charging time or charging point to the user in advance.

[Item 5]

Deterioration suppression system (10) according to Item 1, in which charge recommendation degree generation unit (18) decreases an increase rate of the charge recommendation degree or subtracts an offset from the charge recommendation degree in a case where a deterioration amount in a case of charging at a current temperature of battery (50) is more than or equal to a threshold, the deterioration amount being estimated while referring to charge deterioration characteristics of battery (50) based on the current temperature.

Accordingly, it is possible to generate the charge recommendation degree in consideration of the temperature of battery (50).

[Item 6]

Deterioration suppression system (10) according to Item 1, in which charge recommendation degree generation unit (18) increases a change rate of the charge recommendation degree as a state of health (SOH) of battery (50) is lower, or adds or subtracts a large offset to or from the charge recommendation degree.

Accordingly, it is possible to generate the charge recommendation degree in consideration of the SOH of battery (50).

[Item 7]

Deterioration suppression system (10) according to Item 1, further including charge history retention unit (26) that retains a history of the SOC at a start of charging of battery (50) by a user,

in which charge recommendation degree generation unit (18) changes a change rate of the charge recommendation degree based on a difference between a statistical value of the SOC at the start of charging and the charge start recommendation value to reduce the difference, or changes an offset to be added to or subtracted from the charge recommendation degree.

Accordingly, it is possible to generate the charge recommendation degree in consideration of the tendency of the past charge start timing of the user.

[Item 8]

Deterioration suppression system (10) according to Item 1, further including charge history retention unit (26) that retains a history of the SOC at an end of charging of battery (50) by a user,

in which charge recommendation degree generation unit (18) changes a change rate of the charge recommendation degree based on a difference between a statistical value of the SOC at the end of charging and the charge end recommendation value to reduce the difference, or changes an offset to be added to or subtracted from the charge recommendation degree.

Accordingly, it is possible to generate the charge recommendation degree in consideration of the tendency of the past charge end timing of the user.

[Item 9]

A deterioration suppression method including:

generating a histogram of a residence time of a state of charge (SOC) of battery (50) based on battery data;
specifying, as an actual SOC use range, an SOC range that falls within a predetermined appearance probability from the histogram;
calculating a recommended SOC use range in which deterioration is further suppressed than the actual SOC use range while referring to the deterioration characteristics of battery (50) based on the actual SOC use range and a statistical charge and discharge pattern based on the battery data; and
generating a charge recommendation degree that increases or decreases in accordance with the SOC of battery (50), the charge recommendation degree having a lower limit SOC of the recommended SOC use range as a charge start recommendation value and an upper limit SOC of the recommended SOC use range as a charge end recommendation value.

Accordingly, it is possible to generate a unique index to be presented to the user for bringing the charging timing of the user closer to the charging timing optimum for deterioration suppression.

[Item 10]

A deterioration suppression program for causing a computer to execute a process of:

generating a histogram of a residence time of a state of charge (SOC) of battery (50) based on battery data;
specifying, as an actual SOC use range, an SOC range that falls within a predetermined appearance probability from the histogram;
calculating a recommended SOC use range in which deterioration is further suppressed than the actual SOC use range while referring to deterioration characteristics of battery (50) based on the actual SOC use range and a statistical charge and discharge pattern based on the battery data; and
generating a charge recommendation degree that increases or decreases in accordance with the SOC of battery (50), the charge recommendation degree having a lower limit SOC of the recommended SOC use range as a charge start recommendation value and an upper limit SOC of the recommended SOC use range as a charge end recommendation value.

Accordingly, it is possible to generate a unique index to be presented to the user for bringing the charging timing of the user closer to the charging timing optimum for deterioration suppression.

**REFERENCE MARKS IN THE DRAWINGS**

1     battery-mounted device
2     commercial power system
3     AC adapter
10    controller
11    battery data acquisition unit
12    SOC estimation unit
13    histogram generation unit
14    actual SOC range calculation unit
15    actual charge and discharge pattern generation unit
16    ideal SOC range calculation unit
17    SOH estimation unit
18    charge recommendation degree generation unit
19    display controller
110   charge and discharge controller
20    storage
21    battery data retention unit

22      histogram retention unit
23      charge deterioration characteristic map
24      discharge deterioration characteristic map
25      storage deterioration characteristic map
26      charge history retention unit
30      display unit
40      operation unit
50      battery pack
51      voltage sensor
52      current sensor
53      temperature sensor
60      charger

## Claims

1.  A deterioration suppression system comprising:

    a histogram generation unit that generates a histogram of a residence time of an SOC indicating a state of charge of a battery based on battery data;
    an actual SOC range calculation unit that specifies, as an actual SOC use range, an SOC range that falls within a predetermined appearance probability from the histogram;
    a recommended SOC range calculation unit that calculates a recommended SOC use range in which deterioration is further suppressed than the actual SOC use range based on the actual SOC use range and a statistical charge and discharge pattern based on the battery data while referring to deterioration characteristics of the battery; and
    a charge recommendation degree generation unit that generates a charge recommendation degree that increases or decreases in accordance with the SOC of the battery, the charge recommendation degree having a lower limit SOC of the recommended SOC use range as a charge start recommendation value and an upper limit SOC of the recommended SOC use range as a charge end recommendation value.

2.  The deterioration suppression system according to Claim 1, further comprising a display controller that displays, on a display unit, the charge recommendation degree and at least one of the charge start recommendation value or the charge end recommendation value.

3.  The deterioration suppression system according to Claim 2, wherein

    the display controller
    displays the charge recommendation degree by a bar that expands or contracts in accordance with the SOC of the battery, and
    displays, as a scale, the at least one of the charge start recommendation value or the charge end recommendation value at a predetermined position in an expansion and contraction range of the bar.

4.  The deterioration suppression system according to Claim 2, wherein

    the charge recommendation degree generation unit predicts future SOC transition based on SOC transition of the battery from a predetermined period before to a present, and predicts future transition of the charge recommendation degree, and
    the display controller displays the future transition of the charge recommendation degree.

5.  The deterioration suppression system according to Claim 1, wherein the charge recommendation degree generation unit decreases an increase rate of the charge recommendation degree or subtracts an offset from the charge recommendation degree in a case where a deterioration amount in a case of charging at a current temperature of the battery is more than or equal to a threshold, the deterioration amount being estimated while referring to charge deterioration characteristics of the battery based on the current temperature.

6.  The deterioration suppression system according to Claim 1, wherein the charge recommendation degree generation unit increases a change rate of the charge recommendation degree as an SOH indicating a state of health of the battery is lower, or adds or subtracts a large offset to or from the charge recommendation degree.

**7.** The deterioration suppression system according to Claim 1, further comprising a charge history retention unit that retains a history of the SOC at a start of charging of the battery by a user,

wherein the charge recommendation degree generation unit changes a change rate of the charge recommendation degree based on a difference between a statistical value of the SOC at the start of charging and the charge start recommendation value to reduce the difference, or changes an offset to be added to or subtracted from the charge recommendation degree.

**8.** The deterioration suppression system according to Claim 1, further comprising a charge history retention unit that retains a history of the SOC at an end of charging of the battery by a user,

wherein the charge recommendation degree generation unit changes a change rate of the charge recommendation degree based on a difference between a statistical value of the SOC at the end of charging and the charge end recommendation value to reduce the difference, or changes an offset to be added to or subtracted from the charge recommendation degree.

**9.** A deterioration suppression method comprising:

generating a histogram of a residence time of an SOC indicating a state of charge of a battery based on battery data;
specifying, as an actual SOC use range, an SOC range that falls within a predetermined appearance probability from the histogram;
calculating a recommended SOC use range in which deterioration is further suppressed than the actual SOC use range while referring to the deterioration characteristics of the battery based on the actual SOC use range and a statistical charge and discharge pattern based on the battery data; and
generating a charge recommendation degree that increases or decreases in accordance with the SOC of the battery, the charge recommendation degree having a lower limit SOC of the recommended SOC use range as a charge start recommendation value and an upper limit SOC of the recommended SOC use range as a charge end recommendation value.

**10.** A deterioration suppression program for causing a computer to execute a process of:

generating a histogram of a residence time of an SOC indicating a state of charge of a battery based on battery data;
specifying, as an actual SOC use range, an SOC range that falls within a predetermined appearance probability from the histogram;
calculating a recommended SOC use range in which deterioration is further suppressed than the actual SOC use range while referring to deterioration characteristics of the battery based on the actual SOC use range and a statistical charge and discharge pattern based on the battery data; and
generating a charge recommendation degree that increases or decreases in accordance with the SOC of the battery, the charge recommendation degree having a lower limit SOC of the recommended SOC use range as a charge start recommendation value and an upper limit SOC of the recommended SOC use range as a charge end recommendation value.

**11.** A temporary storage medium having a deterioration suppression program record therein, the deterioration suppression program being executed by the computer according to Claim 10.

# FIG. 1

BATTERY-MOUNTED DEVICE

AC ADAPTER 3

# FIG. 2

# FIG. 3

RESIDENCE
TIME

SOC

ACTUAL SOC
RANGE

$u-k\sigma$        $u+k\sigma$

FIG. 4A

STORAGE
DETERIORATION RATE [%/√h]

SOC[%]

TEMPERATURE [°C]

FIG. 4B

CHARGE
DETERIORATION RATE [%/√Ah]

SOC[%]

CURRENT RATE [C]

FIG. 4C

DISCHARGE
DETERIORATION RATE [%/√Ah]

SOC[%]

CURRENT RATE [C]

# FIG. 5

B1

CHARGE END
RECOMMENDATION
LINE

CHARGE START
RECOMMENDATION
LINE

CHARGE
RECOMMENDATION
DEGREE

# FIG. 6

B1a

FOR USER WHO
USUALLY CHARGES EARLY

B1b

NORMAL

B1c

FOR USER WHO
USUALLY CHARGES LATE

CHARGE END
RECOMMENDATION
LINE

CHARGE START
RECOMMENDATION
LINE

CHARGE
RECOMMENDATION
DEGREE

# FIG. 7

CHARGE
RECOMMENDATION
DEGREE

PREDICTION TRANSITION

CHARGE START
RECOMMENDATION
LINE

L2 OPERATE          L3

CHARGE    L1  DISCHARGE

STOP

CHARGE END
RECOMMENDATION
LINE

TIME

CURRENT
TIME

CHARGE START
RECOMMENDATION
TIME

# FIG. 8

CHARGE
RECOMMENDATION
DEGREE

PREDICTION TRANSITION

CHARGE START
RECOMMENDATION
LINE

L2

CHARGE    L1  DISCHARGE

CHARGE END
RECOMMENDATION
LINE

TRAVEL
DISTANCE

CURRENT
POSITION

CHARGE
RECOMMENDATION
POINT

# FIG. 9

```
                    ┌─────────────┐
                    │   START     │
                    └─────────────┘
                           │
        ┌──────────────────────────────────────────┐
   S10  │ CALCULATE IDEAL SOC USE RANGE FROM        │
        │ STATISTICAL DATA OF BATTERY DATA          │
        └──────────────────────────────────────────┘
                           │
        ┌──────────────────────────────────────────┐
        │ SET LOWER LIMIT SOC OF IDEAL SOC USE      │
        │ RANGE TO CHARGE START RECOMMENDATION      │
   S11  │ VALUE AND UPPER LIMIT SOC TO CHARGE END   │
        │ RECOMMENDATION VALUE                      │
        └──────────────────────────────────────────┘
                           │
        ┌──────────────────────────────────────────┐
   S12  │ ACQUIRE BATTERY DATA                      │
        └──────────────────────────────────────────┘
                           │
        ┌──────────────────────────────────────────┐
   S13  │ CALCULATE CHARGE RECOMMENDATION DEGREE    │
        │ BASED ON CURRENT SOC                      │
        └──────────────────────────────────────────┘
                           │
        ┌──────────────────────────────────────────┐
        │ DISPLAY CHARGE RECOMMENDATION DEGREE,     │
   S14  │ CHARGE START RECOMMENDATION VALUE, AND    │
        │ CHARGE END RECOMMENDATION VALUE           │
        └──────────────────────────────────────────┘
                           │
    N        ◇ IS RECOMMENDATION DEGREE ◇
   S15         DISPLAY ENDED?
                           │ Y
                    ┌─────────────┐
                    │    END      │
                    └─────────────┘
```

## INTERNATIONAL SEARCH REPORT

| International application No. |
| --- |
| **PCT/JP2024/004125** |

### A. CLASSIFICATION OF SUBJECT MATTER

*H02J 7/00*(2006.01)i; *H01M 10/48*(2006.01)i
FI: H02J7/00 Y; H01M10/48 P; H02J7/00 X

According to International Patent Classification (IPC) or to both national classification and IPC

### B. FIELDS SEARCHED

Minimum documentation searched (classification system followed by classification symbols)

H02J7/00; H01M10/48

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2022-146415 A (HONDA MOTOR CO., LTD.) 05 October 2022 (2022-10-05) paragraphs [0012]-[0079], fig. 1-5, 9-12 | 1-11 |
| A | JP 2021-083187 A (TOYOTA JIDOSHA KABUSHIKI KAISHA) 27 May 2021 (2021-05-27) paragraphs [0035]-[0046], fig. 1-4 | 1-11 |
| A | JP 2012-029417 A (HITACHI, LTD.) 09 February 2012 (2012-02-09) paragraphs [0047]-[0056], fig. 9-10 | 1-11 |

☐ Further documents are listed in the continuation of Box C.   ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **27 March 2024** | **09 April 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/004125**

| Patent document cited in search report | | | Publication date (day/month/year) | Patent family member(s) | Publication date (day/month/year) |
|---|---|---|---|---|---|
| JP | 2022-146415 | A | 05 October 2022 | US 2022/0302725 A1<br>paragraphs [0024]-[0091], fig. 1-5, 9-12<br>CN 115107567 A | |
| JP | 2021-083187 | A | 27 May 2021 | (Family: none) | |
| JP | 2012-029417 | A | 09 February 2012 | CN 102347627 A | |

Form PCT/ISA/210 (patent family annex) (July 2022)

**EP 4 672 548 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022035232 A

- JP 2021083187 A